(19) Europäisches Patentamt / European Patent Office / Office européen des brevets

(11) **EP 3 299 836 B1**

(12) **EUROPÄISCHE PATENTSCHRIFT**

(45) Veröffentlichungstag und Bekanntmachung des Hinweises auf die Patenterteilung:
**25.09.2024 Patentblatt 2024/39**

(21) Anmeldenummer: **17173750.5**

(22) Anmeldetag: **31.05.2017**

(51) Internationale Patentklassifikation (IPC):
**G01R 33/563** (2006.01) **G01R 33/565** (2006.01)

(52) Gemeinsame Patentklassifikation (CPC):
**G01R 33/56341; G01R 33/56572**

(54) **LOKALE KORREKTUR VON GRADIENTEN-NICHTLINEARITÄTEN IN DER DIFFUSIONSGEWICHTETEN MRT**

LOCAL CORRECTION OF GRADIENT NON-LINEARITIES IN DIFFUSION WEIGHTED MRI

CORRECTION LOCALE DE NON-LINÉARITÉS DE GRADIENTS DANS L'IRM PONDÉRÉE PAR LA DIFFUSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.03.2018 Patentblatt 2018/13**

(73) Patentinhaber: **Siemens Healthineers AG**
**91301 Forchheim (DE)**

(72) Erfinder:
• **Feiweier, Thorsten**
**91099 Poxdorf (DE)**
• **Nickel, Marcel Dominik**
**91074 Herzogenaurach (DE)**

(74) Vertreter: **Siemens Healthineers**
**Patent Attorneys**
**Postfach 22 16 34**
**80506 München (DE)**

(56) Entgegenhaltungen:
• **DARIYA I. MALYARENKO ET AL: "Practical estimate of gradient nonlinearity for implementation of apparent diffusion coefficient bias correction : Nonlinearity Estimate for ADC Correction", JOURNAL OF MAGNETIC RESONANCE IMAGING, vol. 40, no. 6, 13 November 2013 (2013-11-13), US, pages 1487 - 1495, XP055431192, ISSN: 1053-1807, DOI: 10.1002/jmri.24486**

EP 3 299 836 B1

**Beschreibung**

Die vorliegende Erfindung betrifft die Diffusionsbildgebung mit Hilfe einer Magnetresonanz (MR)-Anlage, und insbesondere ein Verfahren zur lokalen Korrektur von Gradienten-Nicht-linearitäten bei der Diffusionsbildgebung mit Hilfe einer MR-Anlage. Weiter werden eine zugehörige MR-Anlage, ein Computerprogrammprodukt und ein elektronischer Datenträger bereitgestellt.

Die Diffusionsbildgebung mit Hilfe einer MR-Anlage stellt in der heutigen Zeit ein unverzichtbares Verfahren in der medizinischen Diagnostik dar. Eine etablierte Anwendung ist dabei die Bestimmung von spurgewichteten (trace-weighted) MR-Bildern, bei denen richtungsabhängige Diffusionseffekte derart gemittelt werden, dass das Ergebnis rotationsinvariant ist. Auf Basis dieser spurgewichteten MR-Bilder lassen sich auch scheinbare Diffusionskoeffizienten (ADCs) berechnen, die der rotationsinvarianten Spur des Diffusionstensors geteilt durch seine Dimension entsprechen. Diese sind vom MR-Protokoll unabhängige Parameter und gewinnen zunehmend an klinischer Bedeutung.

Der Korrektur unerwünschter Einflussgrößen kommt bei der ADC-Quantifizierung eine große Bedeutung zu. Eine wesentliche Einflussgröße stellt die systematische räumliche Variation der Diffusionsgradientenfelder dar, insbesondere führen durch das Design bedingte Nicht-Linearitäten zu ortsabhängigen Diffusionswichtungen und -richtungen, die unkorrigiert die Erzeugung fehlerhafter spurgewichteter MR-Bilder zur Folge haben.

Für eine unmittelbare Berechnung der ADCs basierend auf drei Diffusionsrichtungen (Trace-Bildgebung) gibt es Arbeiten die auf eine Korrektur der ADC-Werte abzielen, ohne vorher eine möglichst ideale Mittelung von diffusionsgewichteten MR-Bildern zur Erzeugung eines genäherten spurgemittelten MR-Bildes zu finden.

Ein von Malyarenko et al. in Magn. Reson. Med. 71:1312 (2014) beschriebenes Verfahren beschreibt die näherungsweise Korrektur von Gradienten-Nichtlinearitäten bei der Bestimmung des ADC bei der Trace-gewichteten Bildgebung mit drei (nominal orthogonalen) Diffusionsrichtungen.

Aus der Druckschrift "Practical Estimate of Gradient Nonlinearity for Implementation of Apparent Diffusion Coefficient Bias Correction" von Malyarenko et al in Journal of Magnetic Resonance Imaging, Bd. 40, Nr. 6, 13. November 2013, Seiten 1487-1495, ist ein Verfahren zum empirischen Charakterisieren von Gradienten-Nichtlinearitäten für die Bestimmung von ADC-Karten bekannt, welche eine Skalierung von Korrekturfaktoren basierend auf Gradienten-Nichtlinearitäten mittels einer kubischen Spline-Interpolation umfasst, wobei die Diffusionskodierungsrichtungen jeweils orthogonal zueinander sind.

Ein von Bammer et al. in Magn. Reson. Med. 50:560 (2003) beschriebenes Verfahren beschreibt die exakte Korrektur von Gradienten-Nichtlinearitäten bei der Bestimmung der ADCs auf Basis einer Tensor- Rekonstruktion, für die mindestens sechs (nicht kollineare) Diffusionsrichtungen sowie zumindest eine weitere Messung mit abweichender Diffusionswichtung notwendig sind.

DE 10 2010 029 932 A1 beschreibt ein Verfahren zur Korrektur von Bildverzerrungen, welche bei Aufnahmen von diffusionsgewichteten MR-Bildern von einem Untersuchungsobjekt auftreten, wobei ein Referenzbild mittels eines zweiten Aufnahmeprozesses aufgenommen wird.

Heutige MR-Anlagen für Diffusionsbildgebung ignorieren diese Problematik und nehmen ideale lineare Diffusionsgradienten an, was zu systematischen, mit dem Abstand vom Isozentrum zunehmenden, Fehlern in der Bestimmung von spurgewichteten MR-Bildern und davon abgeleiteten ADC-Karten führt.

Es besteht daher Bedarf nach einem verbesserten Verfahren zum Erzeugen von spurgewichteten MR-Bildern und davon abgeleiteten ADC-Karten, welches lokale Nicht-Linearitäten der Diffusionsgradientenfelder auf schnelle und effiziente Weise berücksichtigt.

Diese Aufgabe wird mit den Merkmalen der unabhängigen Ansprüche gelöst. In den abhängigen Ansprüchen sind weitere Ausführungsformen der Erfindung beschrieben.

Gemäß einem ersten Aspekt wird ein Verfahren gemäß Anspruch 1 zum Erzeugen eines genäherten spurgewichteten MR-Bildes eines Untersuchungsobjekts bereitgestellt. In einem ersten Schritt werden mindestens drei diffusionsgewichtete MR-Bilder des Untersuchungsobjekts erstellt, wobei jedes diffusionsgewichtete MR-Bild auf einer Diffusionskodierung basiert. Im Allgemeinen wird die Diffusionskodierung durch eine symmetrische 3x3 Matrix beschrieben. In guter Näherung ist das meistens eine Richtung und ein Betrag, d.h. die Diffusionskodierung kann eine Diffusionskodierungsrichtung und ein zugehöriges Diffusionsgradientenfeld mit einem bestimmten Betrag umfassen. Dabei ist die Diffusionskodierungsrichtung jedes diffusionsgewichteten MR-Bildes unterschiedlich zu den Diffusionskodierungsrichtungen der anderen diffusionsgewichteten MR-Bilder. Weiter weist dabei das Diffusionsgradientenfeld jedes diffusionsgewichteten MR-Bildes im Wesentlichen die gleiche nominelle Diffusionskodierungsstärke auf wie die Diffusionsgradientenfelder der anderen diffusionsgewichteten MR-Bilder. In einem weiteren Schritt werden räumliche Inhomogenitäten der Diffusionsgradientenfelder bestimmt. Räumliche Inhomogenitäten umfassen räumliche Abweichungen der tatsächlichen Diffusionsgradientenfelder von nominell spezifizierten Diffusionsgradientenfeldern. In einem zusätzlichen Schritt wird ein Wichtungsfaktor für jeden Bildpunkt jedes der mindestens drei diffusionsgewichteten MR-Bilder basierend auf den räumlichen Inhomogenitäten durch ein Optimierungsverfahren bestimmt, d.h. eine Wichtungsfaktorkarte wird für jedes der mindestens drei diffusionsgewichteten MR-Bilder bestimmt. In einem weiteren Schritt werden die mindestens drei diffusionsgewichteten MR-Bilder basierend auf den Wichtungsfaktoren kombiniert zum Erzeugen eines genäherten spurgewichteten MR-Bildes.

Das erfindungsgemäße Verfahren erlaubt die Bestimmung von nahezu spurgewichteten MR-Bildern aus zumindest drei Diffusionsmessungen mit unterschiedlichen, nicht orthogonalen Richtungen und gegebenenfalls leicht abweichenden Wichtungen in Situationen, bei denen eine geometrische Mittelung nicht zum gewünschten Resultat führt. Beispielsweise ist dies in Fällen relevant, bei denen die Diffusionsrichtungen räumliche Variationen aufweisen. Insbesondere lassen sich damit systematische räumliche Variationen der Gradientenfelder (z.B. aufgrund von durch das Spulendesign bedingte Nicht-Linearitäten) bei der Bestimmung spurgewichteter MR-Bilder und davon abgeleiteten ADC-Karten berücksichtigen.

Das erfindungsgemäße Verfahren ist vorteilhaft nicht auf eine spezielle Anzahl von Diffusionskodierungen limitiert und betrifft den Fall von Diffusionskodierungsrichtungen, die nicht orthogonal zueinander sind. Insbesondere kann es auch bei der klinisch immer relevanter werdenden tetraedischen "4- Scan-Trace" Kodierung verwendet werden, welche in der Druckschrift Conturo et al.: "Encoding of Anisotropie Diffusion with Tetrahedral Gradients: A General Mathematical Diffusion Formalism and Experimental Results", MRM 35:399 (1996) näher beschrieben ist.

Dabei ist die Diffusionskodierung durch eine symmetrische Matrix, die b-Matrix, beschrieben. In der klinisch relevanten Anwendung hat diese nur einen dominanten Eigenwert, der dann Diffusionsrichtung und Diffusionsstärke definiert. Spurgewichtete Bilder werden erhalten, wenn die b-Matrizen verschiedener Diffusionskodierungen zu einer zur Einheitsmatrix proportionalen Matrix superpositioniert werden. Bei 4-Scan-Trace bilden die dominierenden Diffusionsrichtungen einen Tetraeder (oder alternativ betrachtet 4 von 8 Ecken eines Würfels). Für diese Wahl ist die Summe der äußeren Produkte der Eigenvektoren proportional zur Einheitsmatrix.

Im Unterschied zum Ansatz von Malyarenko et al. kann das erfindungsgemäße Verfahren auch bei mehr als drei Richtungen verwendet werden, und es kann auch bei nicht-orthogonalen Diffusionsrichtungen verwendet werden, wie sie erfindungsgemäß vorliegen. Des Weiteren erlaubt das erfindungsgemäße Verfahren die direkte Bestimmung von nahezu spurgewichteten MR-Bildern, ohne dass zuvor (explizit oder implizit) korrigierte ADCs berechnet werden müssen. Hierfür genügen Diffusionsmessungen mit mehreren (zumindest drei) Richtungen mit nominal identischem b-Wert.

Im Unterschied zum Ansatz von Bammer et al. funktioniert das erfindungsgemäße Verfahren auch in den Fällen, in denen die verfügbaren Daten nicht zur Bestimmung eines Diffusionstensors genügen. Insbesondere können nahezu spurgewichtete MR-Bilder aus Diffusionsmessungen mit weniger als sechs Richtungen bestimmt werden, und aus zumindest drei Diffusionsmessungen mit nominal identischem b-Wert.

Dadurch wird ein verbessertes Verfahren zum Erzeugen von spurgewichteten MR-Bildern und abgeleiteten ADC-Karten bereitgestellt, welches lokale Nicht-Linearitäten der Diffusionsgradientenfelder auf schnelle und effiziente Weise berücksichtigt und somit eine qualitativ höherwertige und kostengünstigere Untersuchung einer Untersuchungsperson mit Hilfe einer MR-Anlage ermöglicht als durch herkömmliche MR-Anlagen ermöglicht wird.

Erfindungsgemäß ist jeder Wichtungsfaktor ein Exponent des Bildsignals des zugehörigen diffusionsgewichteten MR-Bildes. Durch die Ausbildung des Wichtungsfaktors als Exponent des Bildsignals des zugehörigen diffusionsgewichteten MR-Bildes wird ein verbessertes Verfahren zum Erzeugen von spurgewichteten MR-Bildern und abgeleiteten ADC-Karten bereitgestellt.

Erfindungsgemäß umfasst das Kombinieren der diffusionsgewichteten MR-Bilder ein Multiplizieren der Signalstärken der diffusionsgewichteten MR-Bilder, wobei das Bildsignal jedes diffusionsgewichteten MR-Bildes durch die zugehörige Wichtungsfaktorkarte an jedem Bildpunkt als Exponent gewichtet wird. Durch die Wichtung der Bildsignale durch Exponenten bei einer Multiplikation der diffusionsgewichteten MR-Bilder wird eine genauere Kombination der Bildsignale und damit eine weiter verbesserte Qualität der genäherten spurgewichteten MR-Bilder erreicht.

Erfindungsgemäß wird das Kombinieren der diffusionsgewichteten MR-Bilder in jedem Bildpunkt nach der Formel

$$S^{(approximated\ trace)} = \prod_{n=1}^{N} S_n^{\alpha_n}$$

durchgeführt, wobei $S^{(approximated\ trace)}$ das Signal des genäherten spurgewichteten MR-Bildes darstellt, $S_n$ die Signale der gemessenen diffusionsgewichteten MR-Bildern mit N unterschiedlichen Diffusionskodierungen und $\alpha_n$ der ortsabhängige Wichtungsfaktor am gegebenen Bildpunkt eines diffusionsgewichteten MR-Bildes ist. Durch die Wichtung durch die zuletzt genannte Formel wird eine vereinfachte und damit effizientere Kombination der diffusionsgewichteten MR-Bilder ermöglicht.

Das Bestimmen des Wichtungsfaktors für jeden Bildpunkt und für jedes diffusionsgewichtete MR-Bild durch ein Optimierungsverfahren umfasst erfindungsgemäß ein Minimieren eines spurlosen Anteils des genäherten spurgewichteten MR-Bildes.

Durch die Minimierung eines spurlosen Anteils des genäherten spurgewichteten MR-Bildes wird erreicht, dass im erfindungsgemäßen Fall von nicht-orthogonalen Diffusionsrichtungen der diffusionsgewichteten MR-Bilder ein genähertes spurgewichtetes MR-Bild gefunden wird, welches weiter optimiert und verbessert an ein spurgewichtetes MR-Bild angenähert ist.

Die Minimierung des spurlosen Anteils des genäherten spurgewichteten MR-Bildes kann durch eine Minimierung des Terms

$$\left\| R^{(traceless\ spin2\ contribution)} \right\|_F^2 = Tr\left[ \left( \sum_{n=1}^{N} \alpha_n f_n - \frac{1}{3} Tr\left[ \sum_{n=1}^{N} \alpha_n f_n \right] 1 \right)^2 \right]$$

$$= \sum_{m=1}^{N} \sum_{n=1}^{N} \alpha_n \alpha_m \left( Tr[f_m f_n] - \frac{1}{3} Tr[f_n] Tr[f_m] \right)$$

durchgeführt werden, wobei N die Anzahl der diffusionsgewichteten MR-Bildern ist, wobei $f_n$ eine Matrix der effektiven Diffusionskodierungsstärken entsprechend jedem Bildpunkt eines Diffusionsgradientenfelds ist, und wobei $\alpha_n$, $\alpha_m$ die Wichtungsfaktoren von diffusionsgewichteten MR-Bildern am betrachteten Bildpunkt sind. Durch die Minimierung des spurlosen Anteils des genäherten spurgewichteten MR-Bildes durch die Minimierung des zuletzt genannten Terms wird eine effiziente und schnelle rechnerische Lösung des Optimierungsproblems ermöglicht.

Die Minimierung kann unter der Bedingung durchgeführt werden, dass die Wichtungsfaktoren in Summe den Wert 1 ergeben, wodurch das genäherte spurgewichtete MR-Bild proportional zu der Magnetisierung ist und damit einer erhöhte Qualität aufweist.

Die mindestens drei Diffusionskodierungsrichtungen sind erfindungsgemäß nicht orthogonal zueinander. Dadurch kann die Messung der diffusionsgewichteten MR-Bilder einfacher durchgeführt werden. Insbesondere können dadurch Bilddaten der klinisch immer relevanter werdenden tetraedischen "4- Scan-Trace" Kodierung verwendet werden.

Die mindestens drei diffusionsgewichteten MR-Bilder des Untersuchungsobjekts können mindestens vier diffusionsgewichtete MR-Bilder des Untersuchungsobjekts umfassen. Die mindestens drei diffusionsgewichteten MR-Bilder können eine beliebige Anzahl von diffusionsgewichteten MR-Bilder größer drei umfassen. Dadurch, dass das Verfahren nicht auf drei, vier oder eine andere feste Anzahl von diffusionsgewichteten MR-Bilder festgelegt ist, ermöglicht das Verfahren eine flexiblere und effizientere Erzeugung von genäherten spurgewichteten MR-Bildern mit höherer Bildqualität.

Das Verfahren kann einen weiteren Schritt umfassen, wobei eine effektive Diffusionskodierungsstärke für jeden Bildpunkt basierend auf den räumlichen Inhomogenitäten der Diffusionsgradientenfelder und den Wichtungsfaktoren bestimmt wird. Dadurch wird eine lokale Korrektur der Bilddaten ermöglicht.

Die effektive Diffusionskodierungsstärke $b^{effective}$ kann durch die Formel

$$b^{effective} = Tr\left[ \sum_{n=1}^{N} \alpha_n f_n \right]$$

bestimmt werden, wobei N die Anzahl der diffusionsgewichteten MR-Bildern ist, wobei $f_n$ eine Matrix der effektiven Diffusionskodierungsstärke entsprechend jedem Bildpunkt eines Diffusionsgradientenfelds ist, und wobei $\alpha_n$ ein Wichtungsfaktor eines diffusionsgewichteten MR-Bildes entsprechend jedem Bildpunkt ist. Durch die zuletzt genannte Formel kann die Berechnung der lokalen effektiven Diffusionskodierungsstärke schnell und effizient durchgeführt werden.

Das Verfahren kann weiter zum Synthetisieren eines spurgewichteten MR-Bildes bei nomineller Diffusionskodierungsstärke ausgebildet sein, wobei das Verfahren folgende weitere Schritte umfasst. In einem ersten weiteren Schritt können mindestens zwei genäherte spurgewichtete MR-Bilder und die zugehörige effektive Diffusionskodierungsstärken $b^{effective}$ basierend auf mindestens zwei unterschiedlichen nominellen Diffusionskodierungsstärken erzeugt werden. In einem zusätzlichen Schritt kann mindestens eine Karte eines scheinbaren Diffusionskoeffizienten (ADC) unter Verwenden der mindestens zwei genäherten spurgewichteten MR-Bilder und der zugehörigen effektiven Diffusionskodierungsstärken $b^{effective}$ bestimmt werden. In noch einem weiteren Schritt kann ein spurgewichtetes MR-Bild entsprechend einer nominellen Diffusionskodierungsstärke basierend auf der mindestens einen ADC-Karte und einem der genäherten spurgewichteten MR-Bilder erzeugt werden. Das Synthetisieren eines spurgewichteten MR-Bildes bei nomineller Diffusionskodierungsstärke ermöglicht eine verbesserte Bildgebung mit höherer Qualität und damit einer genauere Untersuchung einer Untersuchungsperson.

Gemäß einem weiteren Aspekt der Erfindung wird eine MR-Anlage gemäß Anspruch 9 zum Erzeugen eines genäherten spurgewichteten MR-Bildes bereitgestellt.

Für eine derartige MR-Anlage zum Erzeugen eines genäherten spurgewichteten MR-Bildes können technische Effekte erzielt werden, die vergleichbar sind mit den technischen Effekten, die für das Verfahren gemäß dem ersten Aspekt obenstehend beschrieben wurden.

Gemäß einem weiteren Aspekt der Erfindung wird ein Computerprogrammprodukt gemäß Anspruch 10 bereitgestellt.

Gemäß einem weiteren Aspekt der Erfindung wird ein elektronisch lesbarer Datenträger mit darauf gespeicherten elektronisch lesbaren Steuerinformationen gemäß Anspruch 11 bereitgestellt.

Die oben dargelegten Merkmale und Merkmale, die nachfolgend beschrieben werden, können nicht nur in den entsprechenden explizit dargelegten Kombinationen verwendet werden, sondern auch in weiteren Kombinationen oder isoliert, sofern hierdurch der durch die Ansprüche definierte Schutzumfang der vorliegenden Erfindung nicht verlassen wird.

Die Erfindung wird nachfolgend unter Bezugnahme auf die beiliegenden Zeichnungen näher erläutert.

Figur 1    zeigt schematisch eine MR-Anlage, mit der ein Verfahren zum Erzeugen eines genäherten spurgewichteten MR-Bildes erfindungsgemäß durchgeführt werden kann.

Figur 2    zeigt ein Flussdiagramm mit Schritten zur Durchführung eines Verfahrens zum Erzeugen eines genäherten spurgewichteten MR-Bildes gemäß einem Ausführungsbeispiel der Erfindung.

Figur 3    zeigt ein Flussdiagramm mit Schritten zur Durchführung eines Verfahrens zum Bestimmen einer Karte eines scheinbaren Diffusionskoeffizienten (ADC) gemäß einem Ausführungsbeispiel der Erfindung.

In einem Ausführungsbeispiel der Erfindung wird eine lokale Korrektur von Gradienten-Nichtlinearitäten bei der Diffusionsbildgebung mit Hilfe einer MR-Anlage durchgeführt. Dabei wird für eine gegebene Menge von diffusionsgewichteten MR-Bildern und deren genauer Diffusionskodierung, welche möglicherweise lokal aus Gradienten-Spezifikationen bestimmt wurde, adaptiv eine optimierte Kombination der diffusionsgewichteten MR-Bilder berechnet, die der Spurmittelung möglichst nahe kommt. Falls eine Spurmittelung exakt erreicht werden kann, wird diese gefunden. Andernfalls wird der Effekt der residualen Beiträge minimiert. Das erfindungsbemäße Verfahren ist nicht auf eine spezielle Anzahl von Diffusionskodierungen limitiert, insbesondere kann es auch bei der klinisch immer relevanter werdenden tetraedischen "4- Scan-Trace" Kodierung verwendet werden. Als Ergebnis erhält man auch einen effektiven gemittelten b-Wert, der sich vom nominellen b-Wert unterscheiden kann und der zur Berechnung des ADCs verwendet werden kann.

In der diffusionsgewichteten MR-Bildgebung ist die Wichtung entsprechend der Spur des Diffusionstensors ein wichtiger Kontrast. Die Spur ist eine rotationsunabhängige Größe und ist von den verbleibenden fünf Freiheitsgraden abgekoppelt, welche eine separate nicht reduzierbare Darstellung der Rotationsgruppe bilden. Wie unten im Detail dargestellt werden wird, wird der spurgewichtete Kontrast typischerweise durch ein pixelweises geometrisches Mitteln eines Satzes von geeigneten diffusionsgewichteten MR-Bildern erhalten. Die Diffusionskodierung kann jedoch beispielsweise durch Nicht-Linearitäten der Gradientenfelder von Pixel zu Pixel unterschiedlich sein, sodass das Mittel keine Spurwichtung mehr darstellt und die Diffusionskodierungsstärke kann sich ändern. Für einen bestimmten Satz von erstellten diffusionsgewichteten MR-Bildern und die pixelgenaue Kenntnis der Diffusionskodierung wird eine optimale Kombination, d.h. ein optimales Mittel, der diffusionsgewichteten MR-Bilder bestimmt, um eine Spurwichtung so gut wie möglich anzunähern, weiterhin wird die Diffusionskodierungsstärke bestimmt.

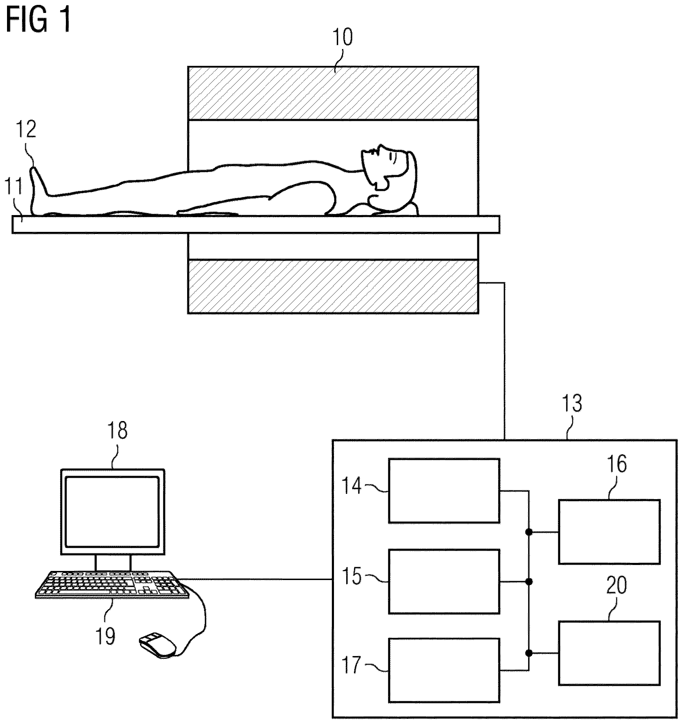

Figur 1 zeigt schematisch eine MR-Anlage, mit der ein Verfahren zum Erzeugen eines genäherten spurgewichteten MR-Bildes erfindungsgemäß durchgeführt werden kann.

Eine Untersuchungsperson 12, oder allgemeiner ein Untersuchungsobjekt, ist in den Tunnel der Anlage gefahren. Die Magnetresonanzanlage weist einen Magneten 10 zur Erzeugung eines Grundfeldes B0 auf, wobei eine auf einer Liege 11 angeordnete Untersuchungsperson 12 in das Zentrum des Magneten gefahren wird, um dort ortscodierte Magnetresonanzsignale aus einem Untersuchungsabschnitt aufzunehmen. Durch Einstrahlen von Hochfrequenzpulsfolgen und Schalten von Magnetfeldgradienten kann die durch das Grundfeld B0 erzeugte Magnetisierung gestört werden durch Auslenkung der Kernspins aus der Gleichgewichtslage, und die bei der Rückkehr in die Gleichgewichtslage in Empfangsspulen induzierten Ströme können in Magnetresonanzsignale umgewandelt werden. Die allgemeine Funktionsweise zur Erstellung von MR-Bildern und die Detektion der Magnetresonanzsignale sind dem Fachmann bekannt, sodass auf eine detaillierte Erläuterung hiervon verzichtet wird.

Die Magnetresonanzanlage weist weiterhin eine MR-Steuereinheit 13 auf, die zur Steuerung des MR-Geräts verwendet wird. Die zentrale MR-Steuereinheit 13, welche derart ausgebildet ist, dass sie das unten beschriebene Verfahren zum Erzeugen eines genäherten spurgewichteten MR-Bildes durchführt, weist eine Gradientensteuerung 14 zur Steuerung und Schaltung der Magnetfeldgradienten auf und eine HF-Steuerung 15 zur Steuerung und Einstrahlung der HF-Pulse zur Auslenkung der Kernspins aus der Gleichgewichtlage. In einer Speichereinheit 16 können beispielsweise die für die Aufnahme der MR-Bilder notwendigen Bildgebungssequenzen abgespeichert werden, sowie alle Programme, die zum Betrieb der MR-Anlage notwendig sind. Eine Aufnahmeeinheit 17 steuert die Bildaufnahme und steuert damit in Abhängigkeit von den gewählten Bildgebungssequenzen die Abfolge der Magnetfeldgradienten und HF-Pulse und die Empfangsintervalle von MR-Signalen. Somit steuert die Aufnahmeeinheit 17 auch die Gradientensteuerung 14 und die HF-Steuerung 15. In einer Recheneinheit 20 können MR-Bilder berechnet werden, die auf eine Anzeige 18 angezeigt werden können, wobei eine Bedienperson über eine Eingabeeinheit 19 die MR-Anlage bedienen kann. Die Speichereinheit 16 kann Bildgebungssequenzen und Programmmodule aufweisen, die bei Ausführung in der Recheneinheit 20 von einem der gezeigten Module, das erfindungsgemäße Verfahren durchführen. Die HF-Steuerung 15 kann weiterhin ausgebildet sein, das Erzeugen eines genäherten spurgewichteten MR-Bildes zu verbessern, wie nachfolgend im Detail erläutert wird. Insbesondere speichert die Speichereinheit 16 dazu von der MR-Steuereinheit 13 ausführbare Steuerinformationen. Weiter ist die Aufnahmeeinheit 17 derart ausgebildet, dass sie das nachfolgend beschriebene Verfahren zum Erzeugen eines genäherten spurgewichteten MR-Bildes durchführen kann.

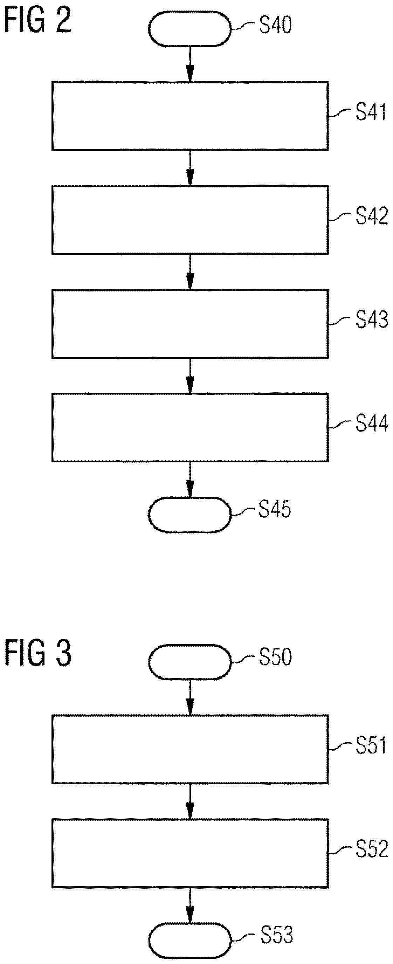

Erfindungsgemäß ist die MR-Anlage der Figur 1 derart ausgebildet, dass sie bei der Ausführung der Steuerinformationen in der MR-Steuereinheit 13 mindestens drei diffusionsgewichteten MR-Bilder erstellt und diese basierend auf einem Optimierungsverfahren, wie in Figur 2 gezeigt, zu einem genäherten spurgewichteten MR-Bild kombiniert.

In einer vereinfachten Darstellung kann das Prinzip der Generierung von Diffusionskontrast von diffusionsgewichteten MR-Bildern wie im Folgenden beschrieben werden. Ein erstes starkes Gradientenmoment wird entlang einer bestimmten Raumrichtung zur Kodierung der aktuellen Position der Kernspins in Form von gespeicherter Phaseninformation angewendet. Nach einer bestimmten Zeit wird ein zweites dem ersten Gradientenmoment entsprechendes Gradientenmoment entlang der gleichen Richtung zur Signalrephasierung angewendet. In dem Fall, dass sich die Position des Kernspins zwischenzeitlich geändert hat - beispielsweise aufgrund einer Diffusionsbewegung - führt dies zu unvollständiger Signalrephasierung und somit zu einer reduzierten Signalamplitude.

Ein derartiges Diffusionsexperiment ist durch zwei Parameter beschreibbar. Zum einen durch die die Diffusionswichtung (Empfindlichkeit auf mikroskopische Bewegung) und die Diffusionsrichtung (Richtungscharakteristik).

Mit der folgenden Darstellung lässt sich das gemessene Signal modellieren:

$$S(\boldsymbol{r}) = S_0(\boldsymbol{r})\, e^{-b\, D(r)}$$

Hierbei stellt $S_0$ das Signal ohne Diffusionswichtung am Ort **r** dar, der b-Wert als der Betrag der **b**-Matrix beschreibt die Diffusionsstärke und D(r) den gewebespezifischen lokalen Diffusionskoeffizienten in die gewählte Diffusionsrichtung.

Figur 2 zeigt ein Flussdiagramm mit Schritten zur Durchführung eines Verfahrens zum Erzeugen eines genäherten spurgewichteten MR-Bildes einer Untersuchungsperson gemäß einem Ausführungsbeispiel der Erfindung.

Das Verfahren startet in Schritt S40. In Schritt S41 werden mindestens drei diffusionsgewichtete MR-Bilder des Untersuchungsobjekts erstellt, wobei jedes diffusionsgewichtete MR-Bild auf einer Diffusionskodierungsrichtung und einem zugehörigen Diffusionsgradientenfeld basiert, wobei die Diffusionskodierungsrichtung jedes diffusionsgewichteten MR-Bildes unterschiedlich ist zu den Diffusionskodierungsrichtungen der anderen diffusionsgewichteten MR-Bilder, und wobei das Diffusionsgradientenfeld jedes diffusionsgewichteten MR-Bildes im Wesentlichen die gleiche nominelle Diffusionskodierungsstärke aufweist wie die Diffusionsgradientenfelder der anderen diffusionsgewichteten MR-Bilder.

Für eine Anzahl n von diffusionskodierten MR-Bildern mit der b-Matrix $\boldsymbol{b_n}$ ist der Bildkontrast (d.h. das Bildsignal) $\boldsymbol{S}_n$ eines diffusionsgewichteten MR-Bildes gegeben durch

$$\boldsymbol{S_n} = \boldsymbol{M}\, e^{-Tr[D\boldsymbol{b_n}]},$$

wobei $\boldsymbol{S}_n$ die Matrix der Bildsignale der Bildpunkte eines diffusionsgewichteten MR-Bildes ist, wobei n eine Diffusionsrichtung kennzeichnet, wobei **M** die Matrix der Magnetisierungen entsprechend den Bildpunkten ist, wobei **D** die 3x3 Diffusionsmatrix der Diffusionskonstanten ist, und wobei $\boldsymbol{b}_n$ die 3x3 Matrix der $b_n$-Werte der Diffusionskodierungsstärke ist.

In einem Fall mit nur einer einzigen Diffusionsrichtung kann die Gleichung als $\boldsymbol{b_n} = b\,\boldsymbol{e_n}\boldsymbol{e}_n^{\dagger}$ geschrieben werden.

Idealerweise gilt im Fall von N verschiedenen Diffusionsrichtungen mit b-Matrizen $\mathbf{b_n}$:

$$\frac{N}{3}b\mathbf{1} = \sum_{n=1}^{N} \mathbf{b_n}$$

In diesem Fall ergibt sich der spurgewichtete Kontrast durch folgende Formel:

$$\prod_{n=1}^{N} S_n^{\frac{1}{N}} = \mathbf{M}e^{-\frac{1}{N}Tr(D\sum_{n=1}^{N} \mathbf{b_n})}$$
$$\mathbf{M}e^{-\frac{1}{3}b\,Tr(D)}$$

In Schritt S42 werden räumliche Inhomogenitäten der Diffusionsgradientenfelder bestimmt.

Unter der Annahme, dass aufgrund der räumlichen Inhomogenitäten der Diffusionsgradientenfelder $\mathbf{b_n}$ ersetzt wird durch $\mathbf{f_n} = \mathbf{Lb_nL}^\dagger$, wird das gleichgewichtete geometrische Mittel erfindungsgemäß ersetzt durch ein verändertes geometrisches Mittel

$$S^{(approximated\ trace)} = \prod_{n=1}^{N} S_n^{\alpha_n}.$$

Dabei ist die L-Matrix der ortsabhängige Gradientenspulen-Tensor $L_{ji}(\mathbf{r}) = (\partial B_z^{\ i}(r)\ /\ \partial j)\ /\ Gi$, mit i,j = x, y, z und das Verfahren wird entsprechend für jeden Bildpunkt durchgeführt.

Weiter sind dabei $S^{(approximated\ trace)}$ das Signal des genäherten spurgewichteten MR-Bildes, $S_n$ die Signale der gemessenen diffusionsgewichteten MR-Bildern mit N unterschiedlichen Diffusionskodierungen, und $\alpha_n$ der ortsabhängige Wichtungsfaktor am gegebenen Bildpunkt eines diffusionsgewichteten MR-Bildes. Weiter müssen die Diffusionsrichtungen nicht zueinander orthogonal sein.

In Schritt S43 wird ein Wichtungsfaktor für jeden Bildpunkt jedes der mindestens drei diffusionsgewichteten MR-Bilder basierend auf den räumlichen Inhomogenitäten bestimmt.

Dabei werden die Wichtungsfaktoren $\alpha_n$ erfindungsgemäß durch ein Optimierungsverfahren bestimmt.

In einem Ausführungsbeispiel ergeben sich dabei die im Folgenden beschriebenen Bedingungen.

Um proportional zu der Magnetisierung zu sein, ist erforderlich, dass die Wichtungsfaktoren $\alpha_n$ die Gleichung

$\sum_{n=1}^{N} \propto_n = 1$ erfüllen.

Um eine Spur des Diffusionstensors zu bestimmen, kann die Zerlegung

$$\sum_{n=1}^{N} \alpha_n \mathbf{f_n} = \frac{1}{3}Tr\left[\sum_{n=1}^{N} \alpha_n \mathbf{f_n}\right]\mathbf{1} + \mathbf{R}^{(traceless\ spin2\ contribution)}$$

durchgeführt werden.

Weiter wird erfindungsgemäß das Ziel verfolgt, den spurlosen rotationsinvarianten Anteil $\mathbf{R}^{(traceless\ spin2\ contribution)}$ des spurgewichteten MR-Bildes zu minimieren.

Weiterhin kann in einem Ausführungsbeispiel der tatsächliche, effektive b-Wert $b^{effective}$ dann durch die Formel

$$b^{effective} = Tr\left[\sum_{n=1}^{N} \alpha_n \mathbf{f_n}\right]$$

bestimmt werden.

In einem Ausführungsbeispiel kann zur Minimierung von $\mathbf{R}^{(traceless\ spin2\ contribution)}$ der Term

$$\left\| R^{(traceless\ spin2\ contribution)} \right\|_F^2 = Tr\left[ \left( \sum_{n=1}^{N} \alpha_n f_n - \frac{1}{3} Tr\left[ \sum_{n=1}^{N} \alpha_n f_n \right] \mathbf{1} \right)^2 \right]$$

$$= \sum_{m=1}^{N} \sum_{n=1}^{N} \alpha_n \alpha_m \left( Tr[f_m f_n] - \frac{1}{3} Tr[f_n] Tr[f_m] \right)$$

unter der Bedingung $\sum_{n=1}^{N} \alpha_n = 1$ minimiert werden.

Dieses Optimierungsproblem kann zu einem (N-1)-dimensionalen quadratischen Problem reduziert werden, welches durch Standardverfahren gelöst werden kann. Geometrisch entspricht dies dem Finden der kleinsten ellipsoiden Hyperfläche, welche eine Hyperebene schneidet oder berührt.

In einem Ausführungsbeispiel werden vorzugsweise $\mathbf{v} = \left( \frac{1}{N}, \dots, \frac{1}{N} \right)^T$ und weiter eine Basis des orthogonalen Raumes derart gewählt, dass gilt

$$\alpha = \mathbf{v} + \mathbf{E}\beta,$$

wobei die Basis selbst nicht orthogonal oder normalisiert sein muss, und wobei **E** die N x (N-1)-dimensionale Matrix der Basisvektoren ist.

Dadurch wird automatisch die Bedingung $\sum_{n=1}^{N} \alpha_n = 1$ sichergestellt.

Indem in einem Ausführungsbeispiel die Matrix

$$A_{mn} = Tr[f_m f_n] - \frac{1}{3} Tr[f_n] Tr[f_m]$$

definiert wird, kann weiterhin $\alpha$ bestimmt werden durch die Gleichung

$$\alpha = \mathbf{v} + \mathbf{E}(\mathbf{E}^T A \mathbf{E})^{-1} \mathbf{E}^T A \mathbf{v}.$$

In einem Ausführungsbeispiel wird für die **E**-Matrix vorzugsweise

$$\mathbf{E} = \begin{pmatrix} 1 & & \\ & \ddots & \\ & & 1 \\ -1 & \dots & -1 \end{pmatrix}$$

gewählt. Damit ergibt sich zusammen mit der Zerlegung

$$A = \begin{pmatrix} a & b \\ b^T & d \end{pmatrix}$$

der Ausdruck

$$\mathbf{E}^T A \mathbf{E} = a - e_N b^T - b e_N^T + d e_N e_N^T$$

wobei $e_{N,i} = 1$ gilt.

Die Matrizenkomponenten sind dann bestimmt durch

$$(E^T A E)_{ij} = A_{ij} - A_{Nj} - A_{iN} + A_{NN}\,.$$

Weiter gilt

$$E^T A v = \frac{1}{N}(a e_N - e_N(b^T e_N + d) + b),$$

wobei für die Matrizenelemente gilt:

$$(E^T A v)_i = \frac{1}{N}\left(\sum_{j=1}^{N-1} A_{ij} - \sum_{j=1}^{N-1} A_{Nj} - A_{NN} + A_{iN}\right)$$

In Schritt S44 werden die mindestens drei diffusionsgewichteten MR-Bilder basierend auf den Wichtungsfaktoren zum Erzeugen des genäherten spurgewichteten MR-Bildes schließlich nach der oben genannten Formel

$$S^{(approximated\ trace)} = \prod_{n=1}^{N} S_n^{\alpha_n}$$

kombiniert. Das Verfahren endet in Schritt S45.

Figur 3 zeigt ein Flussdiagramm mit Schritten zur Durchführung eines Verfahrens zum Bestimmen einer ADC-Karte gemäß einem Ausführungsbeispiel der Erfindung.

Das Verfahren beginnt in Schritt S50. In Schritt S51 werden mindestens zwei genäherte spurgewichteten MR-Bilder und die zugehörigen effektiven Diffusionskodierungsstärken b[effective] erzeugt basierend auf mindestens zwei unterschiedlichen nominellen Diffusionskodierungsstärken nach den Schritten eines der oben beschriebenen Verfahren. In Schritt S52 wird mindestens eine ADC-Karte unter Verwenden der mindestens zwei genäherten spurgewichteten MR-Bilder und der zugehörigen effektiven Diffusionskodierungsstärken b[effective] bestimmt. Das Verfahren endet in Schritt S53.

Zusammenfassend wird eine lokale Korrektur von Gradienten-Nichtlinearitäten bei der Diffusionsbildgebung mit Hilfe einer MR-Anlage durchgeführt, wobei für eine gegebene Menge von diffusionsgewichteten MR-Bildern und deren genauer Diffusionskodierung, eine optimierte Kombination der diffusionsgewichteten MR-Bildern aus mindestens drei Messungen mit unterschiedlichen (nicht kollinearen) Richtungen und ggf. unterschiedlichen Wichtungen derart durchgeführt wird, so dass das Resultat einem spurgewichteten MR-Bild möglichst nahe kommt.

Erfindungsgemäß ist das Verfahren nicht auf eine spezielle Anzahl von Diffusionskodierungen und auf orthogonale Diffusionsrichtungen limitiert, sondern betrifft den Fall von nicht orthogonalen Diffusionskodierungsrichtungen. Insbesondere kann es auch bei der klinisch immer relevanter werdenden tetraedischen "4- Scan-Trace" Kodierung verwendet werden. Als Ergebnis erhält man auch einen effektiven gemittelten b-Wert, der sich vom nominellen b-Wert unterscheiden kann und der zur Berechnung von ADC-Karten verwendet werden kann. Weiterhin kann basierend auf einem spurgewichteten Bild bei effektiver Diffusionskodierungsstärke ein spurgewichtetes MR-Bild bei nomineller Diffusionskodierungsstärke synthetisiert werden.

**Patentansprüche**

1. Verfahren zum Erzeugen eines genäherten spurgewichteten MR-Bildes eines Untersuchungsobjekts, umfassend folgende Schritte:

   - Erstellen von mindestens drei diffusionsgewichteten MR-Bildern des Untersuchungsobjekts, wobei jedes diffusionsgewichtete MR-Bild auf einer Diffusionskodierung umfassend eine Diffusionskodierungsrichtung und ein zugehöriges Diffusionsgradientenfeld basiert, wobei die Diffusionskodierungsrichtung jedes diffusionsgewichteten MR-Bildes unterschiedlich ist zu den Diffusionskodierungsrichtungen der anderen diffusionsgewichteten MR-Bilder, und wobei das Diffusionsgradientenfeld jedes diffusionsgewichteten MR-Bildes im Wesentlichen die gleiche nominelle Diffusionskodierungsstärke aufweist wie die Diffusionsgradientenfelder der anderen diffusionsgewichteten MR-Bilder (S41);

- Bestimmen von räumlichen Inhomogenitäten der Diffusionsgradientenfelder (S42);

- Bestimmen eines Wichtungsfaktors für jeden Bildpunkt jedes der mindestens drei diffusionsgewichteten MR-Bilder basierend auf den räumlichen Inhomogenitäten durch ein Optimierungsverfahren (S43); **dadurch gekennzeichnet, dass** ein

- Kombinieren der mindestens drei diffusionsgewichteten MR-Bilder basierend auf den Wichtungsfaktoren zum Erzeugen des genäherten spurgewichteten MR-Bildes (S44) an jedem Bildpunkt nach der Formel

$$S^{(approximated\ trace)} = \prod_{n=1}^{N} S_n^{\alpha_n}$$

erfolgt, wobei $S^{(approximated\ trace)}$ das Signal des genäherten spurgewichteten MR-Bildes darstellt, $S_n$ die Signale der gemessenen diffusionsgewichteten MR-Bilder mit N unterschiedlichen Diffusionskodierungen und $\alpha_n$ der ortsabhängige Wichtungsfaktor am gegebenen Bildpunkt eines diffusionsgewichteten MR-Bildes ist; wobei das Bestimmen der Wichtungsfaktoren für jedes diffusionsgewichtete MR-Bild ein Minimieren eines spurlosen Anteils des genäherten spurgewichteten MR-Bildes umfasst und die mindestens drei Diffusionskodierungsrichtungen nicht orthogonal zueinander sind.

2. Verfahren nach Anspruch 1, wobei die Minimierung des spurlosen Anteils des genäherten spurgewichteten MR-Bildes durch eine Minimierung des Terms

$$\left\| R^{(traceless\ spin2\ contribution)} \right\|_F^2 = Tr\left[ \left( \sum_{n=1}^{N} \alpha_n f_n - \frac{1}{3} Tr\left[ \sum_{n=1}^{N} \alpha_n f_n \right] 1 \right)^2 \right]$$

$$= \sum_{m=1}^{N} \sum_{n=1}^{N} \alpha_n \alpha_m \left( Tr[f_m f_n] - \frac{1}{3} Tr[f_n] Tr[f_m] \right)$$

durchgeführt wird, wobei N die Anzahl der diffusionsgewichteten MR-Bildern ist, wobei $f_n$ eine Matrix der effektiven Diffusionskodierungsstärken entsprechend jedem Bildpunkt eines Diffusionsgradientenfelds ist, und wobei $\alpha_n$, $\alpha_m$ die Wichtungsfaktoren der diffusionsgewichteten MR-Bilder sind.

3. Verfahren nach einem der vorhergehenden Ansprüche, wobei die Wichtungsfaktoren in Summe den Wert 1 ergeben.

4. Verfahren nach einem der vorhergehenden Ansprüche, wobei die mindestens drei diffusionsgewichteten MR-Bilder des Untersuchungsobjekts mindestens vier diffusionsgewichtete MR-Bilder des Untersuchungsobjekts umfassen.

5. Verfahren nach einem der vorhergehenden Ansprüche, weiter umfassend:

- Bestimmen einer effektiven Diffusionskodierungsstärke für jeden Bildpunkt basierend auf den räumlichen Inhomogenitäten der Diffusionsgradientenfelder und den Wichtungsfaktoren.

6. Verfahren nach Anspruch 5, wobei die effektive Diffusionskodierungsstärke $b^{effective}$ durch die Formel

$$b^{effective} = Tr\left[ \sum_{n=1}^{N} \alpha_n f_n \right]$$

bestimmt wird, wobei N die Anzahl der diffusionsgewichteten MR-Bilder ist, wobei $f_n$ eine Matrix der effektiven Diffusionskodierungsstärke entsprechend jedem Bildpunkt eines Diffusionsgradientenfelds ist, und wobei $\alpha_n$ ein

Wichtungsfaktor eines diffusionsgewichteten MR-Bildes ist.

7. Verfahren zum Bestimmen einer Karte eines scheinbaren Diffusionskoeffizienten (ADC), umfassend folgende Schritte:

- Erzeugen von mindestens zwei genäherten spurgewichteten MR-Bildern und den zugehörigen effektiven Diffusionskodierungsstärken $b^{effective}$ basierend auf mindestens zwei unterschiedlichen nominellen Diffusionskodierungsstärken nach einem Verfahren nach Anspruch 6 (S51);
- Bestimmung mindestens einer Karte des scheinbaren Diffusionskoeffizienten (ADC) unter Verwenden der mindestens zwei genäherten spurgewichteten MR-Bilder und der zugehörigen effektiven Diffusionskodierungsstärken $b^{effective}$ (S52).

8. Verfahren nach Anspruch 7, weiter umfassend:
Erzeugen eines spurgewichteten MR-Bildes entsprechend einer nominellen Diffusionskodierungsstärke basierend auf der mindestens einen ADC-Karte und einem der genäherten spurgewichteten MR-Bilder.

9. MR-Anlage zum Erzeugen eines genäherten spurgewichteten MR-Bildes, wobei die MR-Anlage eine MR-Steuereinheit (13) und eine Speichereinheit (16) aufweist, wobei die Speichereinheit (16) von der MR-Steuereinheit (13) ausführbare Steuerinformationen speichert, und wobei die MR-Anlage ausgebildet ist, bei der Ausführung der Steuerinformationen in der MR-Steuereinheit (13) ein Verfahren nach einem der Ansprüche 1 bis 8 auszuführen.

10. 12. Computerprogrammprodukt, welches ein Programm umfasst, das direkt in einen Speicher einer MR-Steuereinheit (13) einer MR-Anlage ladbar ist, mit Programm-Mitteln, um die Schritte des Verfahrens nach einem der Ansprüche 1 bis 8 auszuführen, wenn das Programm in der MR-Steuereinheit (13) der MR-Anlage ausgeführt wird.

11. Elektronisch lesbarer Datenträger mit darauf gespeicherten elektronisch lesbaren Steuerinformationen, welche derart ausgestaltet sind, dass sie bei Verwendung des Datenträgers in einer MR-Steuereinheit (13) einer MR-Anlage das Verfahren nach einem der Ansprüche 1 bis 8 durchführen.

**Claims**

1. Method for generating an approximated trace-weighted MR image of an examination object, comprising the following steps:

- creating at least three diffusion-weighted MR images of the examination object, wherein each diffusion-weighted MR image is based on a diffusion encoding comprising a diffusion encoding direction and an associated diffusion gradient field, wherein the diffusion encoding direction of each diffusion-weighted MR image is different from the diffusion encoding directions of the other diffusion-weighted MR images, and wherein the diffusion gradient field of each diffusion-weighted MR image has essentially the same nominal diffusion encoding strength as the diffusion gradient fields of the other diffusion-weighted MR images (S41);
- determining spatial inhomogeneities of the diffusion gradient fields (S42);
- determining a weighting factor for each image point of each of the at least three diffusion-weighted MR images based on the spatial inhomogeneities by way of an optimisation method (S43); **characterised in that** a
- combining of the at least three diffusion-weighted MR images based on the weighting factors for generating the approximated trace-weighted MR image (S44) takes place at each image point according to the formula

$$S^{(approximated\ trace)} = \prod_{n=1}^{N} S_n^{\alpha_n}$$

where $S^{(approximated\ trace)}$ represents the signal of the approximated trace-weighted MR image, $S_n$ the signals of the scanned diffusion-weighted MR images where N is different diffusion encodings and $\alpha_n$ the location-dependent weighting factor at the given image point of a diffusion-weighted MR image;

wherein determining the weighting factors for each diffusion-weighted MR image comprises minimising a traceless portion of the approximated trace-weighted MR image and the at least three diffusion encoding directions are not orthogonal to each other.

2. Method according to claim 1, wherein minimising the traceless portion of the approximated trace-weighted MR image is carried out by minimising the term

$$\left\| R^{(traceless\ spin2\ contribution)} \right\|_F^2 = Tr\left[ \left( \sum_{n=1}^{N} \alpha_n f_n - \frac{1}{3} Tr\left[ \sum_{n=1}^{N} \alpha_n f_n \right] \mathbf{1} \right)^2 \right]$$

$$= \sum_{m=1}^{N} \sum_{n=1}^{N} \alpha_n \alpha_m \left( Tr[f_m f_n] - \frac{1}{3} Tr[f_n] Tr[f_m] \right)$$

where N is the number of diffusion-weighted MR images, where $f_n$ is a matrix of the effective diffusion encoding strengths corresponding to each image point of a diffusion gradient field, and wherein $\alpha_n$, $\alpha_m$ are the weighting factors of the diffusion-weighted MR images.

3. Method according to one of the preceding claims, wherein the weighting factors in total produce the value 1.

4. Method according to one of the preceding claims, wherein the at least three diffusion-weighted MR images of the examination object comprise at least four diffusion-weighted MR images of the examination object.

5. Method according to one of the preceding claims, also comprising:

   - determining an effective diffusion encoding strength for each image point based on the spatial inhomogeneities of the diffusion gradient fields and the weighting factors.

6. Method according to claim 5, wherein the effective diffusion encoding strength $b^{effective}$ is determined by the formula

$$b^{effective} = Tr\left[ \sum_{n=1}^{N} \alpha_n f_n \right]$$

where N is the number of diffusion-weighted MR images, where $f_n$ is a matrix of the effective diffusion encoding strength corresponding to each image point of a diffusion gradient field, and where $\alpha_n$ is a weighting factor of a diffusion-weighted MR image.

7. Method for determining an apparent diffusion coefficient (ADC) map, comprising the following steps:

   - generating at least two approximated trace-weighted MR images and the associated effective diffusion encoding strengths $b^{effective}$ based on at least two different nominal diffusion encoding strengths according to a method of claim 6 (S51);
   - determining at least one apparent diffusion coefficient (ADC) map using the at least two approximated trace-weighted MR images and the associated effective diffusion encoding strengths $b^{effective}$ (S52).

8. Method according to claim 7, also comprising:

   - generating a trace-weighted MR image corresponding to a nominal diffusion encoding strength based on the at least one ADC map and one of the approximated trace-weighted MR images.

9. MR system for generating an approximated trace-weighted MR image, wherein the MR system has an MR control unit (13) and a storage unit (16), wherein the storage unit (16) stores control information that can be implemented by the MR control unit (13), and wherein the MR system is designed to carry out a method according to one of claims 1 to 8 when the control information is implemented in the MR control unit (13).

**10.** Computer program product, which comprises a program that can be loaded directly into a storage device of an MR control unit (13) of an MR system, having program means in order to carry out the steps of the method according to one of claims 1 to 8 when the program is executed in the MR control unit (13) of the MR system.

**11.** Electronically readable data carrier having electronically readable control information stored thereon, which is configured in such a way that it carries out the method according to one of claims 1 to 8 when the data carrier is used in an MR control unit (13) of an MR system.

**Revendications**

**1.** Procédé de production d'une image RM approchée pondérée par piste d'un objet en examen, comprenant les stades suivants :

- établissement d'au moins trois images RM pondérées par la diffusion de l'objet en examen, dans lequel chaque image RM pondérée par la diffusion repose sur un codage de diffusion comprenant une direction de codage de diffusion et un champ de gradient de diffusion lui appartenant, dans lequel la direction de codage de diffusion de chaque image RM pondérée par la diffusion est différente des directions de codage de diffusion des autres images RM pondérées par la diffusion, et dans lequel le champ de gradient de diffusion de chaque image RM pondérée par la diffusion a sensiblement la même intensité de codage de diffusion nominale que les champs de gradient de diffusion des autres images RM pondérées par la diffusion (S41) ;
- détermination de défauts d'homogénéité dans l'espace des champs de gradient de diffusion (S42);
- détermination d'un facteur de pondération pour chaque point image de chacune des au moins trois images RM pondérées par la diffusion sur la base des défauts d'homogénéité dans l'espace par un procédé d'optimisation (S43) ;

**caractérisé en ce que**

- il est produit une combinaison des au moins trois images RM pondérées par la diffusion sur la base des facteurs de pondération pour la production de l'image RM approchée pondérée par piste (S44) à chaque point image suivant la formule

$$S^{(approximated\ trace)} = \prod_{n=1}^{N} S_n^{\alpha_n}$$

dans laquelle $S^{(approximated\ trace)}$ représente le signal de l'image RM approchée pondérée par piste, $S_n$ les signaux des images RM pondérées par la diffusion mesurés avec N codages de diffusion différents et $\alpha_n$ est le facteur de pondération en fonction de l'emplacement au point image donné d'une image RM pondérée par la diffusion ;
dans lequel la détermination des facteurs de pondération pour chaque image RM pondérée par la diffusion comprend une minimisation de la composante sans piste de l'image RM approchée pondérée par piste et les au moins trois directions de codage de diffusion ne sont pas orthogonales entre elles.

**2.** Procédé suivant la revendication 1, dans lequel on effectue la minimisation de la composante sans piste de l'image RM approchée pondérée par piste par une minimisation du terme

$$\left\| R^{(traceless\ spin2\ contribution)} \right\|_F^2 = Tr\left[ \left( \sum_{n=1}^{N} \alpha_n f_n - \frac{1}{3} Tr\left[ \sum_{n=1}^{N} \alpha_n f_n \right] 1 \right)^2 \right]$$

$$= \sum_{m=1}^{N} \sum_{n=1}^{N} \alpha_n \alpha_m \left( Tr[f_m f_n] - \frac{1}{3} Tr[f_n] Tr[f_m] \right)$$

dans laquelle N est le nombre des images RM pondérées par la diffusion, dans lequel $f_n$ est une matrice des intensités effectives de codage de diffusion correspondant à chaque point image d'un champ de gradient de diffusion, et dans laquelle $\alpha_n$, $\alpha_m$ sont les facteurs de pondération des images RM pondérées par la diffusion.

3. Procédé suivant l'une des revendications précédentes, dans lequel les facteurs de pondération donnent en somme la valeur 1.

4. Procédé suivant l'une des revendications précédentes, dans lequel les au moins trois images RM pondérées par la diffusion de l'objet en examen comprennent au moins quatre images RM pondérées par la diffusion de l'objet en examen.

5. Procédé suivant l'une des revendications précédentes, comprenant en outre :

- détermination d'une intensité effective de codage de diffusion pour chaque point image sur la base des défauts d'homogénéité dans l'espace des champs de gradient de diffusion et des facteurs de pondération.

6. Procédé suivant la revendication 5, dans lequel on détermine l'intensité $b^{effective}$ effective de codage de diffusion par la formule

$$b^{effective} = Tr\left[\sum_{n=1}^{N} \alpha_n f_n\right]$$

dans laquelle N est le nombre d'images RM pondérées par la diffusion, dans laquelle $f_n$ est une matrice des intensités effectives de codage en diffusion correspondant à chaque point image d'un champ de gradient de diffusion, et dans laquelle $\alpha_n$ est un facteur de pondération d'une image RM pondérée par la diffusion.

7. Procédé de détermination d'une carte d'un coefficient (ADC) de diffusion apparent, comprenant les stades suivants :

- production d'au moins deux images RM approchées pondérées par piste et des intensités $b^{effective}$ effectives de codage de position, qui leur appartiennent, sur la base d'au moins deux intensités de codage de diffusion nominales différentes par un procédé suivant la revendication 6 (S51) ;
- détermination d'au moins une carte du coefficient (ADC) de diffusion apparent en utilisant les au moins deux images RM approchées pondérées par piste et les intensités $b^{effective}$ effectives de codage de diffusion, qui leur appartiennent (S52).

8. Procédé suivant la revendication 7, comprenant en outre :

- production d'une image RM pondérée par piste conformément à une intensité de codage de diffusion nominale reposant sur la au moins une carte ADC et sur l'une des images RM approchées pondérées par piste.

9. Installation RM de production d'une image RM approchée pondérée par piste, dans laquelle l'installation comporte une unité (13) de commande RM et une unité (16) de mémoire, dans laquelle l'unité (16) de mémoire de l'unité (13) de commande RM met en mémoire des informations de commande pouvant être exécutées, et dans laquelle l'installation RM est constituée pour, lors de l'exécution des informations de commande dans l'unité (13) de mémoire RM, exécuter un procédé suivant l'une des revendications 1 à 8.

10. Produit de programme d'ordinateur, qui comprend un programme, qui peut être chargé directement dans la mémoire d'une unité (13) de commande RM d'une installation RM, comprenant des moyens de programme pour exécuter les stades du procédé suivant l'une des revendications 1 à 8, lorsque le programme est exécuté dans l'unité (13) de commande RM de l'installation RM.

11. Support de données, déchiffrable électroniquement, ayant des informations de commande mises en mémoire et déchiffrables électroniquement, qui sont conformées de manière à ce que, lors de l'utilisation du support de données dans une unité (13) de commande RM d'une installation RM, elles exécutent le procédé suivant l'une des revendications 1 à 8.

FIG 1

FIG 2

S40

S41

S42

S43

S44

S45

FIG 3

S50

S51

S52

S53

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010029932 A1

**In der Beschreibung aufgeführte Nicht-Patentliteratur**

- **EIN VON MALYARENKO et al.** *Magn. Reson. Med.,* 2014, vol. 71, 1312

- **VON MALYARENKO et al.** Practical Estimate of Gradient Nonlinearity for Implementation of Apparent Diffusion Coefficient Bias Correction. *Journal of Magnetic Resonance Imaging,* 13. November 2013, vol. 40 (6), 1487-1495